# EUROPEAN PATENT APPLICATION

(11) **EP 4 203 080 A1**
(43) Date of publication of application: **28.06.2023**
(21) Application number: 21857385.5
(22) Date of filing: 06.07.2021
(51) Int. Cl.: H01L 31/18

(54) **PASSIVATION CONTACT BATTERY AND PREPARATION METHOD, AND PASSIVATION CONTACT STRUCTURE PREPARATION METHOD AND APPARATUS**

(30) Priority: 18.08.2020 CN 202010832845
(71) Applicant: Jolywood (Taizhou) Solar Technology Co., Ltd., Taizhou, Jiangsu 225500 (CN)
(72) Inventor: DU, Zheren, Taizhou, Jiangsu 225500 (CN); LU, Junyu, Taizhou, Jiangsu 225500 (CN); JI, Genhua, Taizhou, Jiangsu 225500 (CN); MA, Limin, Taizhou, Jiangsu 225500 (CN); CHEN, Jia, Taizhou, Jiangsu 225500 (CN); LIN, Jianwei, Taizhou, Jiangsu 225500 (CN)
(74) Representative: Plasseraud IP
(86) International application number: PCT/CN2021/104649
(87) International publication number: WO 2022/037289

(57) **Abstract**

The present invention relates to a passivated contact cell and a preparation method thereof, and a preparation method and apparatus for a passivated contact structure. The method comprises steps of: S1: pre-treating a substrate; S2: first depositing a tunneling oxide layer on the substrate in a PECVD process chamber, and then depositing a doped amorphous silicon layer in a PVD process chamber, a first gas is provided in the PECVD process chamber, and a second gas and a target material are provided in the PVD process chamber; the target material contains at least one dopant source-containing target material, and the second gas contains no dopant source gas; or, the target material contains at least one dopant source-containing target material, and the second gas contains a dopant source gas; or, the target material contains no dopant source-containing target material, and the second gas contains a dopant source gas; and the doped amorphous silicon layer comprises n-layers of films, where n≥2, and the n-layers of films at least comprise one doped layer and one non-doped layer; and, S3: annealing the substrate to form a doped polycrystalline silicon layer, so as to complete preparation of a passivated contact structure. In the present invention, the preparation of the tunneling oxide layer and the preparation of the doped polycrystalline silicon layer are continuously completed in a same device, so that the preparation process is simplified.

## Description

### TECHNICAL FIELD

The present invention relates to the technical field of solar cells, and in particular to a passivated contact cell and a preparation method thereof, and a preparation method and apparatus for a passivated contact structure.

### BACKGROUND OF THE PRESENT INVENTION

Due to continuous decrease of the thickness of the crystalline silicon cell substrate, and for a cell piece of a certain thickness, the recombination rate of the surface has a particularly obvious impact on the efficiency of the solar cell when the diffusion length of minority carriers is greater than the thickness of the substrate. Therefore, most of the existing technologies are to passivate the surface of the crystalline silicon. At present, the mainstream passivation technology is to deposit a silicon nitride passivation film on both the front and rear surfaces of the cell, thereby improving the recombination problem. One more advanced technology is adopting tunneling oxide passivating contact technology (TOPCon); the passivating tunneling technology first deposits a tunneling layer on the surface of the substrate and then covers a doped polycrystalline silicon layer, so that the tunneling oxide passivated contact is formed. The tunneling oxide passivating technology can form a tunneling film between the electrodes and the substrate to isolate the contact between the metal electrodes and the substrate, thereby reducing the contact recombination loss. Therefore, the open circuit voltage of the cell can be made very high, and the electrons can tunnel through the film without affecting the current transfer.

A method usually used to prepare the tunneling passivated contact structure in current industrial production is: 1. First grow an oxide layer by thermal oxidation, 2. Then deposit an intrinsic amorphous silicon layer by CVD method (chemical vapor deposition), 3. Finally form a doped polycrystalline silicon layer by method of ion implantation or diffusion. This method has the following disadvantages:
1. Three devices are required to separately complete the above three processes. Although the growth of the oxide layer by thermal oxidation and the deposition of the amorphous silicon layer by CVD can be realized in a same tubular furnace, but due to inconsistent process temperature, it takes longer waiting time for heating-up and cooling down, resulting in low productivity.
2. Doping in step 3, if the method of ion implantation is adopted, the equipment is relatively expensive; if phosphorous diffusion method is adopted, doping on a single surface needs to be realized by using a mask, and the process is relatively complicated.
3. The process temperature in both the thermal oxidation and CVD is above 550°C, and the high temperature will cause large curvature of the wafer, thereby affecting the yield rate of the product. At the same time, the reaction gas will spread to the rear surface of the substrate and then be reacted and deposited to form a film, so as to form a wrapped-around. As a result, a wrapped-around removal step needs to be added, and the cost is increased.

### SUMMARY OF THE PRESENT INVENTION

A purpose of the present invention is to overcome the deficiencies of the prior art and provide a passivated contact cell and a preparation method thereof, and a preparation method and apparatus for a passivated contact structure.

The method for preparing a passivated contact structure provided by the present invention includes the following steps of:
S1: first placing a substrate in a PECVD process chamber to deposit a tunneling oxide layer, and then placing the substrate in a PVD process chamber to deposit a doped amorphous silicon layer, wherein a first gas is provided in the PECVD process chamber, and a second gas and a target material are provided in the PVD process chamber;
the target material contains at least one dopant source-containing target material, and the second gas contains no dopant source gas; or,
the target material contains at least one dopant source-containing target material, and the second gas contains a dopant source gas; or,
the target material contains no dopant source-containing target material, and the second gas contains a dopant source gas;
the doped amorphous silicon layer comprises n-layers of films, where n≥2, and the n-layers of films at least comprise one doped layer and one non-doped layer; and
S2: annealing the substrate to activate the doped amorphous silicon layer to form a doped polycrystalline silicon layer, so as to complete the preparation of the passivated contact structure.

The preparation method for a passivated contact structure provided by the present invention further includes the following auxiliary technical solutions.

Wherein, in the step S1,
the PVD process chamber comprises m independent chambers, where m≥2;
at least one of the m independent chambers is provided with a target material containing no dopant source and fed with a gas containing no dopant source, so that the silicon wafer forms an intrinsic amorphous silicon layer in the chamber; and,
at least one of the m independent chambers is provided with a dopant source-containing target material and fed with a gas containing no dopant source, so that the silicon wafer forms a doped amorphous silicon layer in the chamber; or, at least one of the m independent chambers is provided with a target material containing no dopant source and fed with a gas containing dopant source, so that the silicon wafer forms a doped amorphous silicon layer in the chamber; or, at least one of the m independent chambers is provided with a dopant source-containing target material and fed with a gas containing dopant source, so that the silicon wafer forms a doped amorphous silicon layer in the chamber.

Wherein, in the step S1,
the PVD process chamber comprises an integral chamber, and p regions are arranged in the integral chamber according to the traveling direction of the substrate, where p≥2;
at least one of the p regions is provided with a target material containing no dopant source and fed with a gas containing no dopant source, so that the silicon wafer forms an intrinsic amorphous silicon layer in the region; and,
at least one of the p regions is provided with a target material containing dopant source and fed with a gas containing no dopant source, so that the silicon wafer forms a doped amorphous silicon layer in the region.

Wherein, in the step S1, the doped amorphous silicon layer comprises n-layers of films, where n≥2,and the n-layers of films at least comprise one doped layer and one non-doped layer.

Wherein, in the step S1, the tunneling oxide layer is deposited in the PECVD process chamber by plasma enhanced chemical vapor deposition, and the first gas at least comprises oxygen and/or nitric oxide.

Wherein, the intrinsic amorphous silicon layer is deposited in the PVD process chamber by magnetron spluttering, and the second gas at least comprises one gas of argon, hydrogen or oxygen or a mixed gas composed of any more than one of argon, hydrogen or oxygen.

Wherein, before the step S1, the method further includes:
S1': providing a patterned mask on the substrate to locally deposit the tunneling oxide layer and the doped polycrystalline silicon.

Wherein, in the step S1, after the substrate is placed in the PECVD process chamber to deposit the tunneling oxide layer, the substrate is preheated and then placed in the PVD process chamber to deposit the doped amorphous silicon layer.

Wherein, in the step S1, the temperature in the PVD process chamber is not higher than 350°C, and the thickness of the doped amorphous silicon layer is 50 nm to 350 nm.

The present invention further provides a passivated contact cell, wherein a passivated structure of the passivated contact cell is prepared by the method described above.

The present invention further provides an apparatus for preparing a passivated contact structure, wherein the apparatus is used to prepare the passivated contact structure in the passivated contact cell described above, and the apparatus comprises a PECVD process chamber and a PVD process chamber, wherein,
the PVD process chamber at least comprises a first indepentent chamber and a second indepentent chamber; or
the PVD process chamber comprises an integral chamber, and at least a first region and a second region are arranged in the integral chamber according to the traveling direction of a substrate.

The present invention further provides a method for preparing a passivated contact cell, characterized in: including the following steps of:
S0: pre-treating a substrate to form a texturing structure on the surface of the substrate;
S1: first placing the substrate in a PECVD process chamber to deposit a tunneling oxide layer, and then placing the substrate in a PVD process chamber to deposit a doped amorphous silicon layer, wherein a first gas is provided in the PECVD process chamber, and a second gas and a target material are provided in the PVD process chamber;
the target material contains at least one dopant source-containing target material, and the second gas contains no dopant source gas; or,
the target material contains at least one dopant source-containing target material, and the second gas contains a dopant source gas; or,
the target material contains no dopant source-containing target material, and the second gas contains a dopant source gas; and
the doped amorphous silicon layer comprises n-layers of films, where n≥2, and the n-layers of films at least comprise one doped layer and one non-doped layer; and
S2: annealing the substrate to activate the doped amorphous silicon layer to form a doped polycrystalline silicon layer, so as to complete a passivated contact structure; and
S3: post-treating the substrate.

The implementations of the present invention have the following technical effects.

In the present invention, the passivated contact structure is prepared by using a continuous depositing device, and the preparations of the tunneling oxide layer and the doped polycrystalline silicon layer are continuously completed in a same device, so that the preparation process is simplified, and the interface pollution caused by the step-by-step preparation of the tunneling oxide layer and the amorphous silicon layer is avoided while improving the productivity, thereby improving the passivation effect and the electrical performance of the cell. Meanwhile, in the present invention, the amorphous silicon layer is prepared by PVD, so that the in-situ doping is realized, the subsequent separate phosphorus doping process is reduced, and the problem of poor passivation performance caused by the damage to the tunneling oxide layer from high temperature is avoided. Furthermore, the PVD method has a low process temperature, so that the defects caused by the curvature of the substrate can be greatly reduced. Moreover, in the preparation method of the present invention, the required doping ratio can be adjusted according to the process requirements, thereby achieving a better passivation effect. Finally, the process of the preparation method of the present invention has unifaciality and has no wrapped-around generated, so that the later cleaning step is reduced.

### BRIEF DESCRIPTION OF THE DRAWINGS

FIG. 1 is a schematic sectional view of the cell structure after step S0 in Embodiment 3 and Embodiment 4 of the present invention;
FIG. 2 is a schematic sectional view of the cell structure after step S1" in Embodiment 3 and Embodiment 4 of the present invention;
FIG. 3 is a schematic sectional view of the cell structure after step S2 in Embodiment 3 of the present invention;
FIG. 4 is a schematic sectional view of the cell structure after step S31 in Embodiment 3 of the present invention;
FIG. 5 is a schematic sectional view of the cell structure after step S32 in Embodiment 3 of the present invention;
FIG. 6 is a schematic sectional view of the cell structure after step S33 in Embodiment 3 of the present invention;
FIG. 7 is a schematic sectional view of the cell structure after step S34 in Embodiment 3 of the present invention;
FIG. 8 is a schematic sectional view of the cell structure after step S2 in Embodiment 4 of the present invention;
FIG. 9 is a schematic sectional view of the cell structure after step S31 in Embodiment 4 of the present invention;
FIG. 10 is a schematic sectional view of the cell structure after step S32 in Embodiment 4 of the present invention;
FIG. 11 is a schematic sectional view of the cell structure after step S33 in Embodiment 4 of the present invention;
FIG. 12 is a schematic sectional view of the cell structure after step S34 in Embodiment 4 of the present invention; and
FIG. 13 is a schematic diagram of a preparation apparatus in Embodiment 3 and Embodiment 4 of the present invention;
in which: 1: substrate; 2: tunneling oxide layer; 3: doped polycrystalline silicon layer; 4: silicon nitride antireflection layer; 5: front aluminum oxide passivation layer; 6: silicon nitride antireflection layer; 7: metallizing paste; 8: emitter; 9: rear aluminum oxide passivation layer; 10: laminated passivated antireflection layer; and, 11: groove structure.

### DETAILED DESCRIPTION OF THE PRESENT INVENTION

The present invention will be described below in detail by specific embodiments.

The specific embodiments are merely for explaining the present invention, rather than limiting the present invention. Upon reading this specification, those skilled in the art can make modifications as required without creative contribution to the embodiments, they are protected as long as the modifications are within the scope of the claims of the present invention.

The present invention provides a preparation method for a passivated contact structure, including the following steps of:
S1: first placing a substrate in a PECVD process chamber to deposit a tunneling oxide layer, and then placing the substrate in a PVD process chamber to deposit a doped amorphous silicon layer, wherein a first gas is provided in the PECVD process chamber, and a second gas and a target material are provided in the PVD process chamber;
the target material contains at least one dopant source-containing target material, and the second gas contains no dopant source gas; or,
the target material contains at least one dopant source-containing target material, and the second gas contains a dopant source gas; or,
the target material contains no dopant source-containing target material, and the second gas contains a dopant source gas; and
the doped amorphous silicon layer compreises n-layers of films, where n≥2, and the n-layers of films at least comprise one doped layer and one non-doped layer; and
S2: annealing the substrate to activate the doped amorphous silicon layer to form a doped polycrystalline silicon layer, so as to complete the preparation of the passivated contact structure.

This embodiment essentially contains three parallel technical solutions: (1) The target material in the PVD process chamber is a pure silicon pillar target material, and the second gas in the PVD process chamber contains a dopant source gas, at this time, the dopant source of the substrate in the PVD process chamber is only the dopant source gas. In this doping method, the dopant source is easier to react with the substrate to form the doped amorphous silicon layer, meanwhile the gas doping uniformity is high, the doping square resistance of the whole surface is uniform, and gas doping is easier to realize the doping of high-concentration amorphous silicon layer; (2) The target material in the PVD process chamber is a dopant source-containing target material, and the second gas in the PVD process chamber contains no dopant source gas, at this time, the dopant source of the substrate in the PVD process chamber is only the dopant source-containing target material, this doping method does not need to use the dopant source gas, and has high safety, meanwhile the cost for solid doping is relatively low, so that the cost is saved, and solid doping is easier to realize the quantitative control of the amount of the dopant, and the doping concentration of the doped amorphous silicon film of the substrate is controlled by controlling the amount of the dopant in the dopant source-containing target material; (3) The target material in the PVD process chamber is a dopant source-containing target material, and the gas in the PVD process chamber contains a dopant source gas, at this time, the dopant sources of the substrate in the PVD process chamber are the dopant source-containing target material and the dopant source gas, the doping method combining the both integrates the advantages of both gas doping and solid doping, the doping is uniform, and the doping concentration can be higher, so that the passivation level of the passivated contact structure is improved, meanwhile the higher doping concentration can reduce the contact resistivity and metal recombination of the passivated contact structure.

It is to be noted that, the gas in this embodiment is an inert gas and/or hydrogen, the dopant source-containing gas is a phosphorus-containing doping gas or a boron-containing doping gas, and the target material containing no dopant source is a pure silicon pillar target material.

The preparation method of the present invention is simple in process, convenient to operate, safe and reliable, stable in quality, high in productive efficiency, easy to realize large-scale industrial production, and easy to update and integrate the existing production lines.

In one embodiment, in the step S1,
the PVD process chamber comprises m independent chambers, where m≥2;
at least one of the m independent chambers is provided with a target material containing no dopant source and fed with a gas containing no dopant source, so that the silicon wafer forms an intrinsic amorphous silicon layer in the chamber; and
at least one of the m independent chambers is provided with a dopant source-containing target material and fed with a gas containing no dopant source, so that the silicon wafer forms a doped amorphous silicon layer in the chamber; or, at least one of the m independent chambers is provided with a target material containing no dopant source and fed with a gas containing dopant source, so that the silicon wafer forms a doped amorphous silicon layer in the chamber; or, at least one of the m independent chambers is provided with a dopant source-containing target material and fed with a gas containing dopant source, so that the silicon wafer forms a doped amorphous silicon layer in the chamber.

In this embodiment, by superposing the m chambers, the deposition of the laminated doped amorphous silicon film can be realized, the optimal concentration of the doped amorphous silicon layer is that the doping concentration gradually increases from the interface of the tunneling oxide layer to the doped amorphous silicon layer. The low doping concentration near the interface of the tunneling oxide layer can make the passivation level of the passivated contact structure higher, and the high concentration near the interface of the doped amorphous silicon layer can make the metal contact recombination and the contact resistivity lower. The superposition of the chambers makes it easier to realize the laminated doped amorphous silicon film with a gradually varying doping concentration.

In one embodiment, in the step S1,
the PVD process chamber comprises an integral chamber, and p regions are arranged in the integral chamber according to the traveling direction of the substrate, where p≥2;
at least one of the p regions is provided with a target material containing no dopant source and fed with a gas containing no dopant source, so that the silicon wafer forms an intrinsic amorphous silicon layer in the region; and
at least one of the p regions is provided with atarget material containing dopant source and fed with a gas containing no dopant source, so that the silicon wafer forms a doped amorphous silicon layer in the region.

In one embodiment, in the step S1, the doped amorphous silicon layer comprises n-layers of films, where n≥2, and the n-layers of films at least comprise one doped layer and one non-doped layer.

In this embodiment, by arranging the doped amorphous silicon layer to comprise n-layers of films to form a multilayer tunneling structure, it is easier to obtain the best effects of the metal contact recombination and the contact resistivity.

Optionally, in the step S1, the tunneling oxide layer is deposited in the PECVD process chamber by plasma enhanced chemical vapor deposition, and the first gas at least comprises oxygen and/or nitric oxide.

Optionally, in the step S1, the intrinsic amorphous silicon layer is deposited in the PVD process chamber by magnetron spluttering, and at least comprises one gas of argon, hydrogen or oxygen or a mixed gas composed of any more than one of argon, hydrogen or oxygen. Optionally, before the step S1, the method further includes:
S1': providing a patterned mask on the substrate to locally deposit the tunneling oxide layer and the doped polycrystalline silicon.

In this embodiment, by providing a mask on the substrate, the efficiency of the cell piece is improved.

In one embodiment, in the step S1, after the substrate is placed in the PECVD process chamber to deposit the tunneling oxide layer, the substrate is preheated and then placed in the PVD process chamber to deposit the doped amorphous silicon layer.

Preferably, in the step S1, the temperature in the PVD process chamber is not higher than 350°C, and the thickness of the doped amorphous silicon layer is 50 nm to 350 nm.

The present invention further provides a passivated contact cell, wherein a passivated structure of the passivated contact cell is prepared by the method described above.

The present invention further provides an apparatus for preparing a passivated contact structure, wherein the apparatus is used to prepare the passivated contact structure in the passivated contact cell described above, and the apparatus comprises a PECVD process chamber and a PVD process chamber, wherein
the PVD process chamber at least comprises a first independent chamber and a second independent chamber; or
the PVD process chamber comprises an integral chamber, and at least a first region and a second region are arranged in the integral chamber according to the traveling direction of a substrate.

The present invention further provides a method for preparing a passivated contact cell, including the following steps of:
S0: pre-treating a substrate to form an texturing structure on the surface of the substrate;
S1: first placing the substrate in a PECVD process chamber to deposit a tunneling oxide layer, and then placing the substrate in a PVD process chamber to deposit a doped amorphous silicon layer, wherein a first gas is provided in the PECVD process chamber, and a second gas and a target material are provided in the PVD process chamber;
the target material contains at least one dopant source-containing target material, and the second gas contains no dopant source gas; or,
the target material contains at least one dopant source-containing target material, and the second gas contains a dopant source gas; or,
the target material contains no dopant source-containing target material, and the second gas contains a dopant source gas; and
the doped amorphous silicon layer comprises n-layers of films, where n≥2, and the n-layers of films at least comprise one doped layer and one non-doped layer;
S2: annealing the substrate to activate the doped amorphous silicon layer to form a doped polycrystalline silicon layer, so as to complete a passivated contact structure; and
S3: post-treating the substrate.

In the present invention, the passivated contact structure is prepared by using a continuous plating device, and the preparations of the tunneling oxide layer and the doped polycrystalline silicon layer are continuously completed in a same device, so that the preparation process is simplified, and the interface pollution caused by the step-by-step preparation of the tunneling oxide layer and the amorphous silicon layer is avoided while improving the productivity, thereby improving the passivation effect and the electrical performance of the cell. Meanwhile, in the present invention, the amorphous silicon layer is prepared by PVD, so that the in-situ doping is realized, the subsequent separate phosphorus doping process is reduced, and the problem of poor passivation performance caused by the damage to the tunneling oxide layer from high temperature is avoided. Furthermore, the PVD method has a low process temperature, so that the defects caused by the curvature of the substrate can be greatly reduced. Moreover, in the preparation method of the present invention, the required doping ratio can be adjusted according to the process requirements, thereby achieving a better passivation effect. Finally, the process of the preparation method of the present invention has unifaciality and has no winding plating generated, so that the later cleaning step is reduced.

The method for preparing a passivated contact structure and the method for preparing a passivated contact cell provided by the present invention will be described below in detail by specific embodiments.

### Embodiment 1

The method for preparing a passivated contact structure will be described in detail in this embodiment.

Step S0: an N-type substrate 1 was selected, and the substrate was pre-treated to form a texturing structure on the surface of the substrate, the n-type crystalline silicon substrate had a resistivity of 0.3 Ω·cm to 5 Ω·cm and a thickness of 80 µm to 200 µm.

Step S1: the substrate 1 pre-treated in the step S0 was placed in a loading chamber for loading and entered a PECVD process chamber, a tunneling oxide layer 2 generated by plasma excitation in the PECVD process chamber, the gas fed into the PECVD process chamber was oxygen. After the deposition of the tunneling oxide layer 2 was completed in the PECVD process chamber, the substrate entered PVD process chamber, where the PVD process chamber comprised two independent chambers, and argon was fed into the process chamber, a pure silicon pillar target material was provided in the first chamber, and a target material containing a phosphorus dopant source was provided in the second chamber, an amorphous silicon film was deposited on the surface of the substrate by the method of magnetron sputtering, while depositing the amorphous silicon film, the amorphous silicon film was doped in the second chamber. The amorphous silicon film contained a two-layers structure of amorphous silicon layers, and each layer of the amorphous silicon layer had a thickness of 25 nm to 300 nm, wherein the first layer was a non-doped amorphous silicon layer, and the second layer was a phosphorus-doped amorphous silicon layer.

Step S2: the substrate was annealed to activate the doped amorphous silicon layer to form a doped polycrystalline silicon layer 3, so as to complete the preparation of the passivated contact structure.

### Embodiment 2

The method for preparing a passivated contact structure will be described in detail in this embodiment.

Step S0: a P-type substrate 1 was selected, and the substrate was pre-treated to form a texturing structure on the surface of the substrate, the n-type crystalline silicon substrate had a resistivity of 0.1 Ω·cm to 5 Ω·cm and a thickness of 80 µm to 200 µm.

Step S1: the substrate pre-treated in the step S0 was placed in a loading chamber for loading and entered a PECVD process chamber, a tunneling oxide layer 2 generated by plasma excitation in the PECVD process chamber, where the tunneling oxide layer had a thickness of 0.5 nm to 3 nm, the gas fed into the PECVD process chamber was oxygen. After the deposition of the tunneling oxide layer 2 was completed in the PECVD process chamber, the substrate entered a PVD process chamber, where the PVD process chamber comprised two independent chambers, and argon was fed into the process chamber, a pure silicon pillar target material was provided in the first chamber, and a target material containing a phosphorus dopant source was provided in the second chamber, an amorphous silicon film was deposited on the surface of the substrate by the method of magnetron sputtering, while depositing the amorphous silicon film, the amorphous silicon film was doped in the second chamber. The amorphous silicon film contained a two-layers structure of amorphous silicon layers, and each layer of the amorphous silicon layer had a thickness of 25 nm to 300 nm, wherein the first layer was a non-doped amorphous silicon layer, and the second layer was a phosphorus-doped amorphous silicon layer.

Step S2: the substrate was annealed to activate the doped amorphous silicon layer to form a doped polycrystalline silicon layer 3, so as to complete the preparation of the passivated contact structure.

### Embodiment 3

The method for preparing a passivated contact cell will be described in detail in this embodiment.

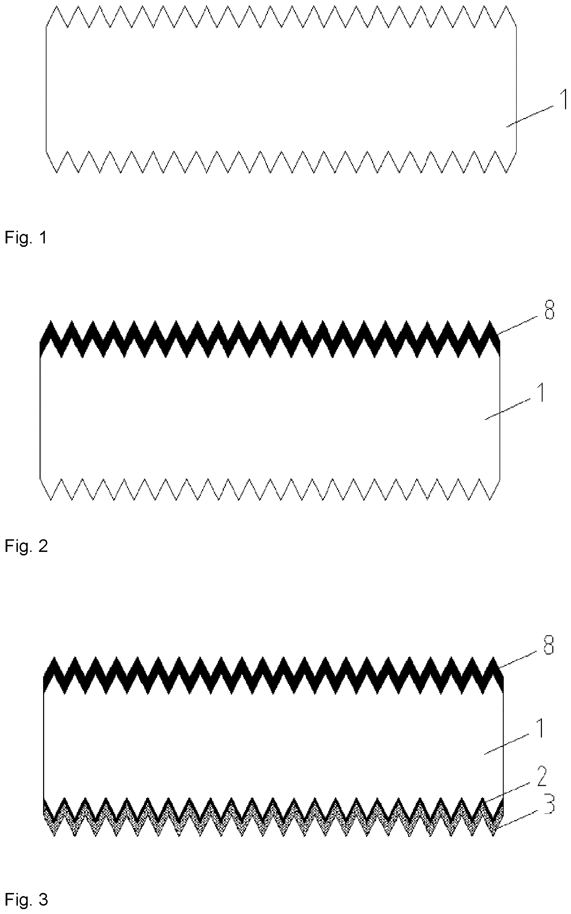

Step S0: an N-type substrate 1 was selected, and the substrate was pre-treated to form a texturing structure on the surface of the substrate, the n-type crystalline silicon substrate had a resistivity of 0.3 Ω·cm to 5 Ω·cm and a thickness of 80 µm to 200 µm. The cell structure at the end of this step was shown in FIG. 1.

Step S1": the substrate was subjected to boron diffusion to form an emitter 8 and then was cleaned. The BBrs gaseous source was used for diffusion, the square resistance was 80 to 200 Ω/sq, and the surface concentration was 5e18cm⁻³ to 2e19cm⁻³. The cell structure at the end of this step was shown in FIG. 2.

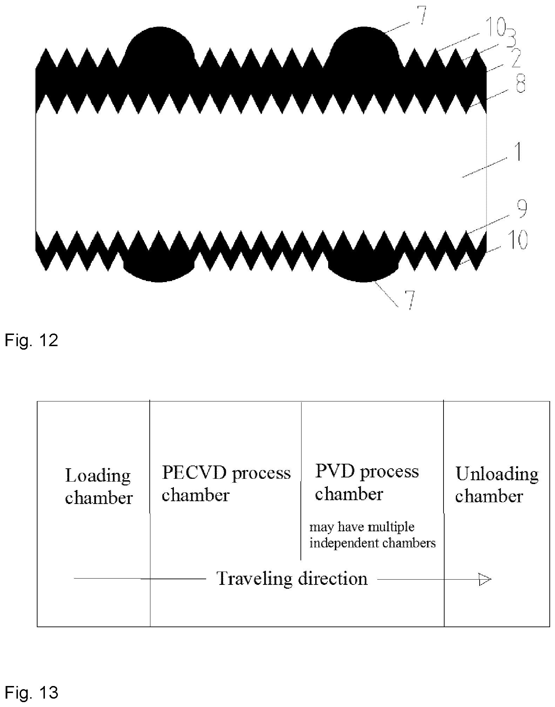

Step S1: the substrate 1 pre-treated in the step S1" was placed in the loading chamber of FIG. 13 for loading and entered a PECVD process chamber, a tunneling oxide layer 2 generated by plasma excitation in the PECVD process chamber, the gas fed into the PECVD process chamber was oxygen. After the deposition of the tunneling oxide layer 2 was completed in the PECVD process chamber, the substrate entered PVD process chamber, where the PVD process chamber comprised two independent chambers, and argon was fed into the process chamber, a pure silicon pillar target material was provided in the first chamber, and a target material containing a phosphorus dopant source was provided in the second chamber, an amorphous silicon film was deposited on the rear surface of the substrate by the method of magnetron sputtering, while depositing the amorphous silicon film, the amorphous silicon film was doped in the second chamber. The amorphous silicon film contained a two-layers structure of amorphous silicon layers, and each layer of the amorphous silicon layer had a thickness of 25 nm to 300 nm, wherein the first layer was a non-doped amorphous silicon layer, and the second layer was a phosphorus-doped amorphous silicon layer.

Step S2: the substrate was annealed to activate the doped amorphous silicon layer to form a doped polycrystalline silicon layer 3, so as to complete the preparation of the passivated contact structure, the annealing temperature was 860°C to 950°C, the annealing time was 15 min to 80 min, and the square resistance of the polycrystalline silicon film after annealing was 20 to 100 Ω/sq. The cell structure at the end of this step was shown in FIG. 3.

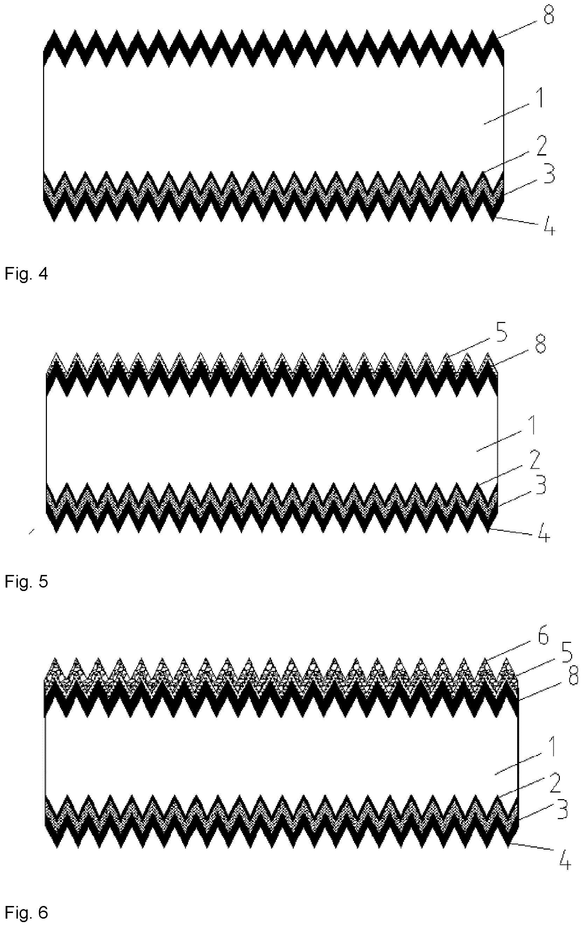

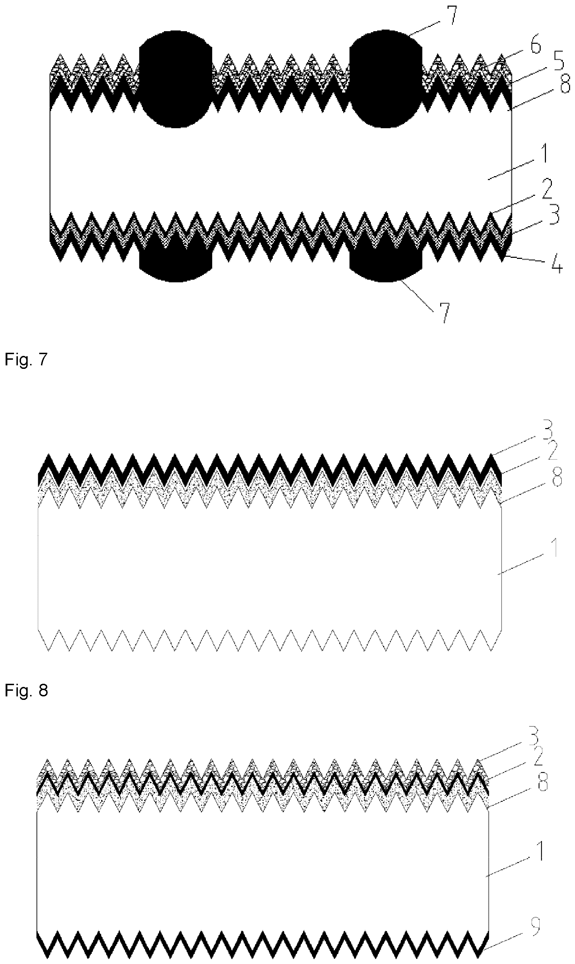

Step S3: the substrate was post-treated, including:
Step S31: a silicon nitride antireflection layer 4 was prepared on the rear surface of the substrate. The cell structure at the end of this step was shown in FIG. 4.
Step s32: a front aluminium oxide passivation layer 5 was prepared on the front surface of the substrate. The cell structure at the end of this step was shown in FIG. 5.
Step S33: a silicon nitride antireflection layer 6 was prepared on the front surface of the substrate. The cell structure at the end of this step was shown in FIG. 6.
Step S34: metallizing paste 7 was screen-printed on both the front and rear surfaces of the substrate and then was sintered. The cell structure at the end of this step was shown in FIG. 7.

### Embodiment 4

The method for preparing a passivated contact cell will be described in detail in this embodiment.

Step S0: a P-type substrate 1 was selected, and the substrate was pre-treated to form a texturing structure on the surface of the substrate, the n-type crystalline silicon substrate had a resistivity of 0.1 Ω·cm to 5 Ω·cm and a thickness of 80 µm to 200 µm. The cell structure at the end of this step was shown in FIG. 1.

Step S1": the substrate was subjected to boron diffusion to form an emitter 8 and then was cleaned. The POCl₃ gaseous source was used for diffusion, the square resistance was 40 to 200 Ω/sq, and the surface concentration was 5e18cm⁻³ to 2e19cm⁻³. The cell structure at the end of this step was shown in FIG. 2.

Step S1: the substrate pre-treated in the step S1" was placed in the loading chamber of FIG. 13 for loading and entered a PECVD process chamber, a tunneling oxide layer 2 generated by plasma excitation in the PECVD process chamber, where the tunneling oxide layer had a thickness of 0.5 nm to 3 nm, and the gas fed into the PECVD process chamber was oxygen. After the deposition of the tunneling oxide layer 2 was completed in the PECVD process chamber, the substrate entered a PVD process chamber, where the PVD process chamber comprised two independent chambers, and argon was fed into the process chamber, a pure silicon pillar target material was provided in the first chamber, and a target material containing a phosphorus dopant source was provided in the second chamber, an amorphous silicon film was deposited on the front surface of the substrate by the method of magnetron sputtering, while depositing the amorphous silicon film, the amorphous silicon film was doped in the second chamber. The amorphous silicon film contained a two-layers structure of amorphous silicon layers, and each layer of the amorphous silicon layer had a thickness of 25 nm to 300 nm, wherein the first layer was a non-doped amorphous silicon layer, and the second layer was a phosphorus-doped amorphous silicon layer.

Step S2: the substrate was annealed to activate the doped amorphous silicon layer to form a doped polycrystalline silicon layer 3, so as to complete the passivated contact structure, the annealing temperature was 860°C to 950°C, the annealing time was 15 min to 80 min, and the square resistance of the polycrystalline silicon film after annealing was 20 to 100 Ω/sq. The cell structure at the end of this step was shown in FIG. 8.

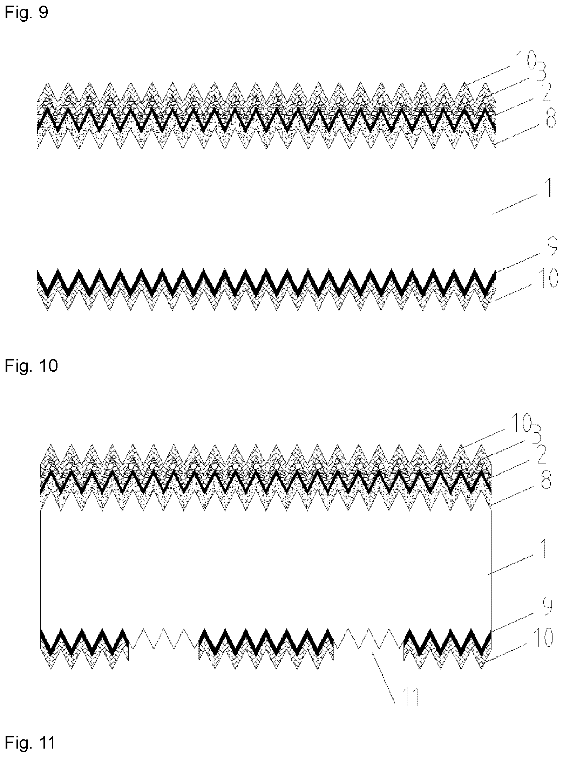

Step S3: the substrate was post-treated, including:
Step S31: a rear aluminium oxide passivation layer 9 was prepared on the rear surface of the substrate. The cell structure at the end of this step was shown in FIG. 9.
Step s32: a laminated passivated antireflection layer 10 was prepared on both the front and rear surfaces of the substrate. The cell structure at the end of this step was shown in FIG. 10.
Step S33: a groove structure 11 was formed on the rear surface of the substrate by laser. The cell structure at the end of this step was shown in FIG. 11.
Step S34: metallizing paste 7 was screen-printed on both the front and rear surfaces of the substrate and then was sintered. The cell structure at the end of this step was shown in FIG. 12.

Finally, it should be noted that the above embodiments are merely for describing the technical solutions of the present invention, rather than limiting the protection scope of the present invention. Although the present invention has been described in detail with reference to the preferred embodiments, it should be understood by those skilled in the art that the technical solutions of the present invention can be modified or equivalently replaced without departing from the essence and scope of the technical solutions of the present invention.

## Claims

1. A method for preparing a passivated contact structure, wherein, comprising the following steps of:
S1: first placing a substrate (1) in a PECVD process chamber to deposit a tunneling oxide layer (2), and then placing the substrate (1) in a PVD process chamber to deposit a doped amorphous silicon layer, a first gas is provided in the PECVD process chamber, and a second gas and a target material are provided in the PVD process chamber;
the doped amorphous silicon layer comprises n-layers of films, where n≥2, and the n-layers of films at least contain one doped layer and one non-doped layer; the target material contains at least one dopant source-containing target material, and the second gas contains no dopant source gas; or,
the target material contains at least one dopant source-containing target material, and the second gas contains a dopant source gas; or,
the target material contains no dopant source-containing target material, and the second gas contains a dopant source gas; and
S2: annealing the substrate (1) to activate the doped amorphous silicon layer to form a doped polycrystalline silicon layer (3), so as to complete the preparation of the passivated contact structure.

2. The preparation method according to claim 1, wherein, in the step S1,
the PVD process chamber comprises m independent chambers, where m≥2;
at least one of the m independent chambers is provided with a target material containing no dopant source and fed with a gas containing no dopant source, so that the silicon wafer forms an intrinsic amorphous silicon layer in the chamber; and,
at least one of the m independent chambers is provided with a dopant source-containing target material and fed with a gas containing no dopant source, so that the silicon wafer forms a doped amorphous silicon layer in the chamber; or, at least one of the m independent chambers is provided with a target material containing no dopant source and fed with a dopant source-containing gas, so that the silicon wafer forms a doped amorphous silicon layer in the chamber; or, at least one of the m independent chambers is provided with a dopant source-containing target material and fed with a dopant source-containing gas, so that the silicon wafer forms a doped amorphous silicon layer in the chamber.

3. The preparation method according to claim 1, wherein, in the step S1,
the PVD process chamber comprises an integral chamber, and p regions are arranged in the integral chamber according to the traveling direction of the substrate (1), where p≥2;
at least one of the p regions is provided with a target material containing no dopant source and fed with a gas containing no dopant source, so that the silicon wafer forms an intrinsic amorphous silicon layer in the region; and
at least one of the p regions is provided with a dopant source-containing target material and fed with a gas containing no dopant source, so that the silicon wafer forms a doped amorphous silicon layer in the region.

4. The preparation method according to any one of claims 1 to 3, wherein, in the step S1,
the tunneling oxide layer (2) is deposited in the PECVD process chamber by plasma enhanced chemical vapor deposition, and the first gas at least comprises oxygen and/or nitric oxide.

5. The preparation method according to any one of claims 1 to 3, wherein, in the step S1,
the intrinsic amorphous silicon layer is deposited in the PVD process chamber by magnetron spluttering, and the second gas at least comprises one gas of argon, hydrogen or oxygen or a mixed gas composed of any more than one of argon, hydrogen or oxygen.

6. The preparation method according to any one of claims 1 to 3, wherein, before the step S1, the method further comprising:
S1': providing a patterned mask on the substrate (1) to locally deposit the tunneling oxide layer (2) and the doped polycrystalline silicon

7. The preparation method according to claim 1 or 2, wherein, in the step S1,
after the substrate (1) is placed in the PECVD process chamber to deposit the tunneling oxide layer (2), the substrate (1) is preheated and then placed in the PVD process chamber to deposit the doped amorphous silicon layer.

8. The preparation method according to claim 6, wherein, the substrate (1) is placed in the PECVD process chamber for preheating, or the substrate (1) is transferred to a heating chamber for preheating.

9. The preparation method according to claim 1 or 2, wherein, in the step S1,
the temperature in the PVD process chamber is not higher than 350°C, and the thickness of the doped amorphous silicon layer is 50 nm to 350 nm.

10. A passivated contact cell, wherein, a passivated structure of the passivated contact cell is prepared by the method according to any one of claims 1 to 9.

11. An apparatus for preparing a passivated contact structure, wherein, the apparatus is used to prepare the passivated contact structure in the passivated contact cell according to claim 11, and the apparatus comprises a PECVD process chamber and a PVD process chamber, wherein,
the PVD process chamber at least comprises a first independent chamber and a second independent chamber; or
the PVD process chamber comprises an integral chamber, and at least a first region and a second region are arranged in the integral chamber according to the traveling direction of a substrate (1).

12. A method for preparing a passivated contact cell, wherein, comprising the following steps of:
S1: first placing a substrate (1) in a PECVD process chamber to deposit a tunneling oxide layer (2), and then placing the substrate (1) in a PVD process chamber to deposit a doped amorphous silicon layer, a first gas is provided in the PECVD process chamber, and a second gas and a target material are provided in the PVD process chamber;
the target material contains at least one dopant source-containing target material, and the second gas contains no dopant source gas; or,
the target material contains at least one dopant source-containing target material, and the second gas contains a dopant source gas; or,
the target material contains no dopant source-containing target material, and the second gas contains a dopant source gas; and
the doped amorphous silicon layer comprises n-layers of films, where n≥2, and the n-layers of films at least contain one doped layer and one non-doped layer;
S2: annealing the substrate (1) to activate the doped amorphous silicon layer to form a doped polycrystalline silicon layer (3), so as to complete a passivated contact structure; and
S3: post-treating the substrate (1).
